Europäisches Patentamt

European Patent Office

Office européen des brevets

(19)

(11) Publication number: **0 083 195**
**B1**

(12) **EUROPEAN PATENT SPECIFICATION**

(45) Date of publication of patent specification: **19.11.87**

(21) Application number: **82306836.6**

(22) Date of filing: **21.12.82**

(51) Int. Cl.⁴: **G 11 C 11/40,** G 11 C 8/00

(54) Decoder circuit for a semiconductor device.

(30) Priority: **28.12.81 JP 209754/81**

(43) Date of publication of application:
**06.07.83 Bulletin 83/27**

(45) Publication of the grant of the patent:
**19.11.87 Bulletin 87/47**

(84) Designated Contracting States:
**DE FR GB**

(56) References cited:
EP-A-0 017 990
GB-A-1 505 812

IEEE INTERNATIONAL SOLID-STATE CIRCUITS
CONFERENCE, vol. 20, no. 20, February 1977,
pages 14-15, New York, USA; T.R. O'CONNELL
et al.: "A 4K static clocked and nonclocked
RAM design"

PATENTS ABSTRACTS OF JAPAN, vol. 5, no.
134(P-77)(806), 26th August 1981

(73) Proprietor: **FUJITSU LIMITED**
**1015, Kamikodanaka Nakahara-ku**
**Kawasaki-shi Kanagawa 211 (JP)**

(72) Inventor: **Oritani, Atushi c/o FUJITSU LIMITED**
**Patent Dept. 1015 Kamikodanaka Nakahara-ku**
**Kawasaki-shi Kanagawa 211 (JP)**

(74) Representative: **Sunderland, James Harry et al**
**HASELTINE LAKE & CO Hazlitt House**
**28 Southampton Buildings Chancery Lane**
**London WC2A 1AT (GB)**

Courier Press, Leamington Spa, England.

## Description

This invention relates to a decoder circuit for use in a semiconductor device for example a semiconductor memory device such as an MOS static RAM for example.

Various strategies for reducing power consumption in semiconductor memory devices have been tried. For example, in accordance with one proposed strategy, as indicated in an article entitled "Integrated Scratch Pads Sire New Generation of Computers" on pages 118 to 126 of "Electronics", April 4, 1966 (see page 122), power consumption of peripheral circuits is reduced by disconnecting the power supply lines of the peripheral circuits (including a decoder circuit, a write circuit, a read circuit) associated with non-selected memory cells in response to a control signal. The aforementioned control signal is sometimes called a chip select signal and is used for control to connect power supply lines to the peripheral circuits of the one selected memory chip only.

Only one bit or several bits of data held in memory cells of a selected memory chip are actually required (that is, within the selected memory chip not all memory cells are ultimately to be selected; only one cell or a few cells are ultimately selected) and a decoder circuit to be selected with the selected cell or cells functions as a decoder for that one or several bits of data. However, other decoder circuits are all in a non-selected condition. Such decoder circuits generally have a NOR gate structure in MOS static RAM etc, with the result that they have a relatively large power consumption in a non-selected condition.

Thus, the problem of power consumption is not solved by the power saving strategy involving the use of a chip select signal.

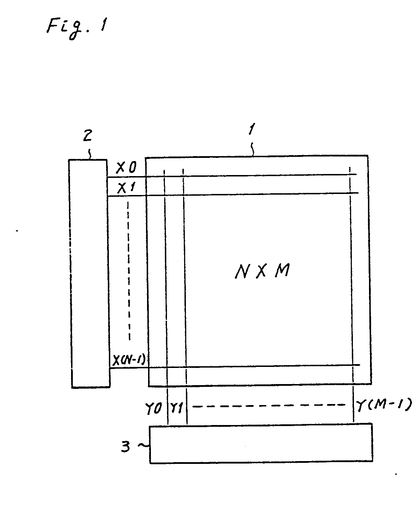

Figure 1 of the accompanying drawings illustrates in outline a known static RAM. In Figure 1, a static memory cell array 1 is shown which comprises $N \times M$ memory cells, for holding data bits, arranged in the form of a matrix. A word decoder 2 is operable to select any one of word lines $X_0$ to $X_{(N-1)}$, whilst a column decoder 3 is operable to select any one of bit lines $Y_0$ to $Y_{(M-1)}$, whereby a cell located at the intersection of a selected word line and a selected bit line is selected, making it possible to read data stored in or to write data into the selected cell. Power consumption of such a static RAM becomes significant when memory capacity becomes large. In particular a word decoder circuit for selecting a word line is at a high level when a NOR gate thereof, which receives a selection address, selects the word line and is at low level when it does not select the word line. Consequently there is a difficulty in reducing power consumption in a semiconductor memory device because such a decoder circuit consumes more power when it is at a low level than when it is at a high level and because word line selecting circuits (word decoder circuits) in a non-selected condition surpass in number those in the selected condition.

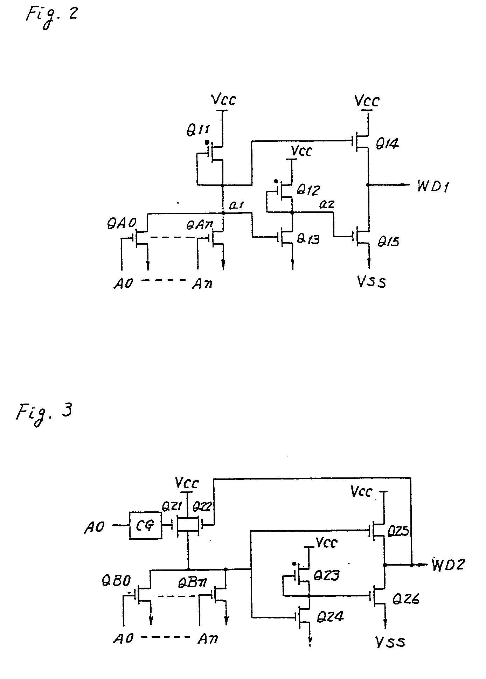

Figure 2 of the accompanying drawings is a circuit diagram of a typical current decoder circuit as explained above.

In Figure 2, $A_0$ to $A_n$ are address signal inputs; $QA_0$ to $QA_n$ are transistors forming a NOR gate, whilst Q11 is a transistor which acts as a load of the NOR gate. $Q_{13}$ is a transistor which acts as an inverter, whilst $Q_{12}$ is a transistor which acts as a load of the inverter. $Q_{14}$ and $Q_{15}$ are transistors which form an output circuit. $V_{cc}$ is a power supply, whilst $V_{ss}$ is the return side of the power supply.

The transistors having a dot adjacent thereto (see transistors $Q_{11}$ and $Q_{12}$) are depletion type MOS transistors.

In the circuit of Figure 2, since address signals $A_0$ to $A_n$ are all low level when the word line with which the circuit is associated is selected, an output of the NOR gate (see point a1 in Figure 2) is at a high level and an output of inverter (see point a2 in Figure 2) is at a low level. This causes the transistor $Q_{14}$ of the output circuit to become ON and $Q_{15}$ OFF. Output WD1 becomes high level and since no current flows into the transistor $Q_{15}$ nor the transistors $QA_0$ to $QA_n$, the circuit consumes less power.

When the word line with which the circuit is associated is not selected, at least one of the address signals $A_0$ to $A_n$ is high level and as a result the point a1 is at low level, whilst the point a2 is at high level, so that the transistor $Q_{14}$ is OFF, and $Q_{15}$ is ON. In this case, since at least one of transistors $QA_0$ to $QA_n$ is ON, current flows consuming power.

Decoder circuits of the conventional type explained above have a disadvantage in that they consume a considerable proportion of the power to be consumed by the memory device, because each consumes more power when the word line with which it is associated is non-selected than when the line is selected, the number of such circuits in the non-selected condition in a memory device surpasses the number in the selected condition.

EP—A1—0 017 990 discloses an internal timing generator circuit of a memory device, which generates an internal clock signal when address inputs are applied thereto and are subject to a change. The internal clock signal is fed to functional circuits, such as an address inverter buffer and to decoder circuits, to control their operations.

GB—A—1 505 812 discloses an address decoder according to the precharacterising portion of Claim 1. One of the two load transistors connected to the NOR gate receives a chip enable signal (before supply of the address signals) for precharging the NOR gate output line; the other receives the decoder output signal and is turned on when that signal is at a 'selected' level.

According to the present invention there is provided a decoder circuit, for example for a semiconductor memory device, operable in response to address signals supplied thereto to provide an output signal at either a first, selected, or a second, non-selected, level in dependence upon the supplied address signals, comprising a logic circuit stage having a NOR gate arranged for receiving such address signals, the logic circuit stage being operable to provide a logic output of a level dependent upon the supplied address signals and the NOR gate being connected to a load comprising a pair of transistors connected in parallel with one another, one of those transistors being arranged to turn on when the logic output has a level such that the output signal takes the selected level, and to turn off when the logic output has a level such that the output signal takes the non-selected level,

characterised in that there are provided means operable to turn on the other one of the transistors of the load, for a preselected time, in synchronisation with a transition of an address signal.

Embodiments of the present invention can provide decoder circuits offering reduced power consumption in a non-selected condition.

An embodiment of the present invention can provide for a drastic reduction in power consumption by a decoder circuit on the basis that a load of a NOR gate thereof, which NOR gate responds to selection addresses, is electrically not connected (only) when the decoder circuit including the NOR gate does not select an associated word line.

Reference is made, by way of example, to the accompanying drawings, in which:—

Figure 1 is a schematic diagram illustrating in outline an ordinary static type semiconductor memory device,

Figure 2 is a schematic circuit diagram of a decoder circuit of conventional semiconductor memory device,

Figure 3 is a schematic circuit diagram of a decoder circuit of a semiconductor memory device in accordance with a first embodiment of the present invention,

Figure 4 is a schematic circuit diagram of a second embodiment of the present invention,

Figure 5 is a waveform diagram for assistance in explanation of operation of the circuits of Figure 3 and Figure 4,

Figure 6 is a schematic circuit diagram illustrating the structure of a clock generating circuit CG found in Figure 3 and Figure 4, and

Figure 7 is a waveform diagram for assistance in explanation of operation of the circuit of Figure 6.

In Figure 3, signals $A_0$ to $A_n$ are address input signals and are respectively connected to gates of transistors $QB_0$ to $QB_n$ which together form a NOR gate. Sources of the transistors $QB_0$ to $QB_n$ are connected to a return side $V_{ss}$ of a power supply $V_{cc}$, whilst drains of those transistors are connected together and connected to the power supply $V_{cc}$ via a first transistor $Q_{21}$ and a second transistor $Q_{22}$, which transistors act as load for the NOR gate. The load transistors $Q_{21}$ and $Q_{22}$ are connected in parallel with one another and an output of a clock signal generating circuit CG is supplied to the gate of transistor $Q_{21}$. An output of the NOR gate is supplied to the gate of a transistor $Q_{24}$ which operates as an inverter, the source of transistor $Q_{24}$ being connected to $V_{ss}$ whilst its

drain is connected to $V_{cc}$ via a depletion type MOS transistor $Q_{23}$ which acts as a load for the inverter. An output of transistor $Q_{24}$ is supplied to the gate of a transistor $Q_{26}$ in an output circuit. The source of transistor $Q_{26}$ is connected to $V_{ss}$, whilst its drain is connected to the source of a transistor $Q_{25}$ of the output circuit. The common connection point of the drain of $Q_{26}$ and the source of transistor $Q_{25}$ is connected, as shown by WD2, to circuits external of the decoder circuit and is also connected to the gate of the transistor $Q_{22}$. The drain of transistor $Q_{25}$ is connected to $V_{cc}$, whilst its gate is connected to the output of the NOR gate.

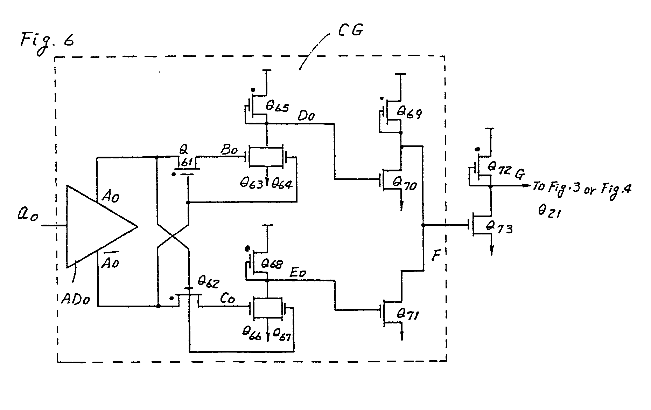

Operations of the circuit of Figure 3 will be explained hereunder in detail. When an address signal (e.g. $A_0$, see below) varies, the output of the clock signal generating circuit CG rises to generate a clock signal which remains at a high level for a certain short period of time. That is, whenever an address signal appears—i.e. whenever a stable address signal becomes available e.g. on an address line connected to the clock signal generating circuit—the clock signal is generated. In Figure 5, (1) shows a waveform of the address signal concerned and waveform of the inverted address signal, and (2) shows a waveform of the clock signal provided by CG.

In Figure 5, (1) the inclined lines correspond to periods in which a stable signal is not available, for example has not yet been established or is being removed to make way for a new signal.

The clock signal generating circuit CG receives, for example, the address input signal $A_0$, inverts its polarity by means of an inverter and provides an output by AND operation between the inverted signal delayed by a capacitor and the original signal $A_0$.

When all of the address input signal $A_0$ to $A_n$ are at low level, the NOR gate is, if the clock signal is at high level, the high level (i.e. the NOR gate output at the common connection point of transistors $QB_0$ to $QB_n$ is at high level) since a load is formed by the transistor $Q_{21}$. When the output of the NOR gate is high level, the output of the transistor $Q_{24}$, and thus the gate of transistor $Q_{26}$, is at low level, and the gate of transistor $Q_{25}$ is at high level, causing the transistor $Q_{25}$ to become ON and the transistor $Q_{26}$ to become OFF. Therefore, the output WD2 of the decoder circuit is high level, driving a word line associated with the decoder circuit. Simultaneously, the output WD2 turns ON the transistor $Q_{22}$. Thereby, even when the clock signal falls to low level and the transistor $Q_{21}$ becomes OFF, operation of NOR gate is maintained, maintaining the word line selecting condition of the decoder circuit.

In Figure 5, (3) shows the waveform of the address input signals, whilst (4) shows that of the NOR gate output, (5) shows that of the inverter ($Q_{24}$) output and (7) shows that of output WD2.

If at least one of the address input signals $A_0$ to $A_n$ is at high level, an output of the NOR gate is at low level, whilst the output of the inverter is at high level only when the clock signal is at high level, and thereby the same operations as are provided by the conventional circuit are executed. Thereby, the output WD2 is at low level and the associated word line is in the non-selected condition. When the clock signal falls to low level DC current is caused to flow only into the transistor $Q_{23}$ since the load of the NOR gate is not electrically connected thereto, thus drastically reducing consumption of current. Therefore, the duration of a clock signal at the high level should be set to a period sufficiently shorter than the period for which a memory cell is selected (when it is selected) and thereby power consumption of the decoder circuit in the non-selected condition of a word line can be reduced significantly.

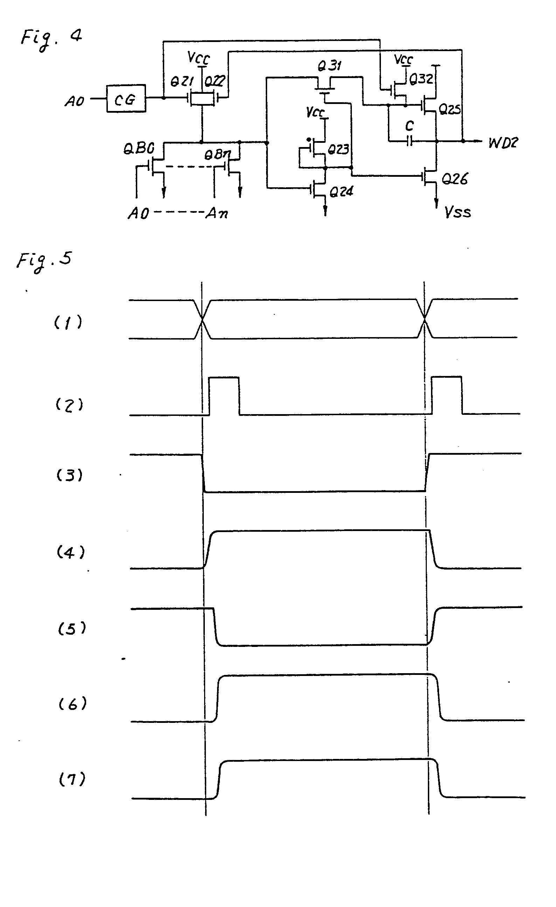

Figure 4 shows another embodiment of the present invention.

The circuit of Figure 4 is similar to that of Figure 3 except in the following three respects:— a transistor $Q_{31}$ is provided between the output of the NOR gate and the gate of transistor $Q_{25}$ of the output circuit and the output of the inverter $(Q_{24})$ is supplied to the gate of transistor $Q_{31}$; the gate of transistor $Q_{25}$ is connected to the power supply $V_{cc}$ via a transistor $Q_{32}$ and the output of the clock signal generator CG is supplied to the gate of transistor $Q_{32}$; a capacitor C is connected between the output (WD2) of the output circuit and the gate of transistor $Q_{25}$.

The combination of the capacitor C and the transistor $Q_{32}$ enables, by virtue of a bootstrap effect, high speed rise of the output signal (at WD2) as compared with a conventional circuit, thus providing for high speed drive of memory cells. The third transistor $Q_{31}$ electrically disconnects the output of NOR gate from the gate of transistor $Q_{25}$ of the output circuit when the inverter $(Q_{24})$ output is at low level, promoting said bootstrap effect. In Figure 5, (6) shows the waveform at the gate of transistor $Q_{25}$ in the embodiment of Figure 4. Other operations of the embodiment of Figure 4 are the same as those of Figure 3 and further explanation is therefore omitted here.

Figure 6 illustrates an example of a clock signal generating circuit CG which can be employed in the embodiments of Figure 3 and Figure 4.

In Figure 6, $a_o$ is an address signal input terminal, $AD_o$ is an address buffer, $Q_{61}$, $Q_{62}$, $Q_{65}$, $Q_{68}$, $Q_{69}$ and $Q_{72}$ are depletion type MOS transistors, $Q_{63}$, $Q_{64}$, $Q_{66}$, $Q_{67}$, $Q_{70}$, $Q_{71}$, $Q_{73}$ are enhancement type MOS transistors.

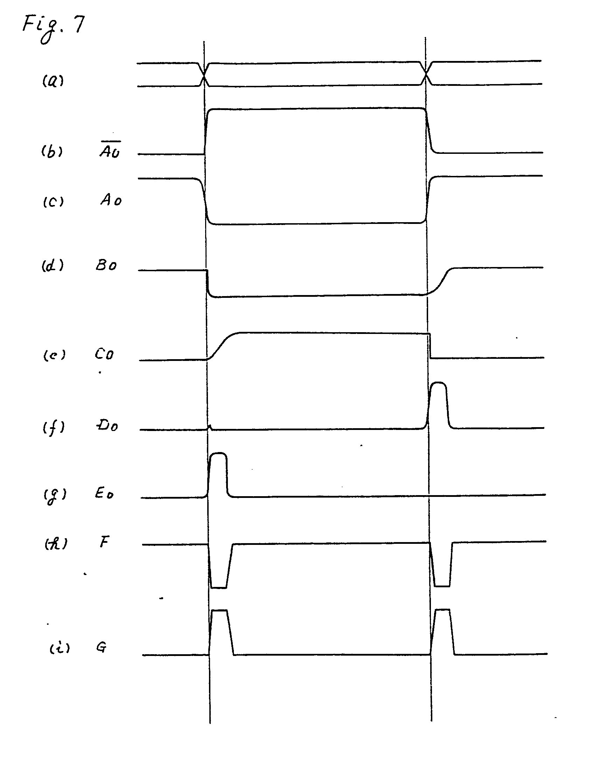

Figure 7 is an operational time chart of the clock signal generating circuit of Figure 6, indicating waveforms at respective circuit points thereof. $A_o$, $\overline{A}_o$, . . . G are waveforms occurring at respective points labelled $A_o$, $\overline{A}_o$, . . . G in Figure 6.

As shown in Figure 7, (a), when the address signal varies (i.e. when an address signal appears, or is stably established) and it is applied to the address signal input terminal $a_o$, it is held by the address buffer $AD_o$, causing outputs $A_o$, $\overline{A}_o$ of the address buffer $AD_o$ to vary as shown in (b). Since the transistors $Q_{61}$, $Q_{62}$ are depletion type MOS transistors, the outputs $A_o$, $\overline{A}_o$ appear at the gates of transistors $Q_{63}$ and $Q_{66}$.

The transistors $Q_{61}$ and $Q_{62}$ form a Delayed Inverter giving a slow rise time in a structure which provides a fast fall time. Therefore the waveforms at $B_o$ and $C_o$ (the gates of $Q_{63}$, $Q_{66}$) change as shown in (d) and (e).

The drain $D_o$ of transistor $Q_{65}$ remains at high level until the transistor $Q_{63}$ becomes OFF ($\overline{A}_o$ is in the LOW state) and the transistor $Q_{64}$ becomes ON ($B_o$ rises to the HIGH state). In the same way the drain $E_o$ of transistor $Q_{68}$ remains at high level until the transistor $Q_{66}$ becomes OFF ($A_o$ is in the LOW state) and the transistor $Q_{67}$ becomes ON ($C_o$ rises to the HIGH state). These waveforms are shown at (f) and (g) in Figure 7. These signals are combined by the transistors $Q_{69}$, $Q_{70}$, $Q_{71}$, and the waveform at the point F changes as shown in (h) and is then inverted by the final stage transistors $Q_{72}$ and $Q_{73}$. Thereby pulses G having the desired duration time can be obtained at points where the address signal (a) varies as shown at (i) in Figure 7.

The pulses G are then applied to the gate of transistor $Q_{21}$ shown in Figure 3 and Figure 4.

Embodiments of the present invention, as explained above, can provide an outstanding effect by achieving a reduction in current which may flow into a transistor circuit when the word line associated with the circuit is non-selected and thereby power consumption in the decoder circuit can be reduced drastically.

Moreover, the use of a clock signal generating circuit as shown in Figure 6 can assure that a clock pulse in a final stage can be delayed more quickly and without a capacitor by once inputting the outputs A, $\overline{A}$ of the address buffer into the delayed inverter and by making the rise time slow or the fall time very fast of the outputs $B_o$ or $C_o$ of the delayed inverter.

The present invention provides a decoder circuit of semiconductor memory device wherein a logic circuit stage which receives an address signal as an input and selects addresses is provided; a load transistor of said logic circuit is composed of a pair of transistors connected in parallel; the one of these transistors turns ON for the specified period in synchronization which said address signal, while the other turns ON when the logic circuit stage is in the selective condition but turns OFF when it is in the non-selective condition.

In the decoder circuit said logic circuit stage, comprising of a NOR gate, may provide an inverter which receives an output of said NOR gate and an output circuit which receives an output of said NOR gate an an output of said inverter.

The decoder circuit may further comprise a clock signal generating circuit which rises when an address signal varies and generates the clock signal which has the specified duration time and the one of said pair of transistors connected in parallel is connected to said clock signal generating circuit.

In the decoder circuit the other of said pair of transistors connected in parallel may be connected to the output of said output circuit.

The decoder circuit may further comprise the third transistor which is connected between said NOR gate and said output circuit, the fourth transistor connected between the joint of said output circuit and said third transistor and the power supply, and the capacitor connected between the joint of said output circuit and said third transistor and the output of said output circuit.

In such a decoder circuit an output of said clock generating circuit is supplied to the gate of said fourth transistor while an output of said inverter is supplied to the gate of said third transistor.

In a decoder circuit in accordance with the invention such a clock signal generating circuit may provide an address buffer which outputs an address signal and inverted output of said address signal, delayed inverter circuits respectively connected to both outputs of said address buffer, outputs of said delayed inverter being respectively input to the gate of the one of transistors connected in parallel, and an output of address buffer being input respectively to the gate of the other transistor.

The clock signal generating circuit may further comprise an inverter which inverts the NOR signal of the outputs of parallel transistor circuits respectively connected to said delayed inverter circuits.

**Claims**

1. A decoder circuit, for example for a semiconductor memory device, operable in response to address signal (Ao to An) supplied thereto to provide an output signal (WD2) at either a first, selected, or a second, non-selected, level in dependence upon the supplied address signals, comprising a logic circuit stage having a NOR gate (QBo to QBn) arranged for receiving such address signals, the logic circuit stage being operable to provide a logic output of a level dependent upon the supplied address signals and the NOR gate being connected to a load comprising a pair of transistors (Q21, Q22) connected in parallel with one another, one of those transistors (Q22) being arranged to turn on when the logic output has a level such that the output signal takes the selected level, and to turn off when the logic output has a level such that the output signal takes the non-selected level, characterised in that there are provided means (CG) operable to turn on the other one of the transistors (Q21) of the load, for a preselected time, in synchronisation with a transition of an address signal (Ao).

2. A decoder circuit as claimed in claim 1, wherein the logic circuit stage further comprises an inverter (Q23, Q24) arranged to receive the output of the NOR gate (QBo to QBn), and the decoder circuit further comprises an output stage (Q25, Q26), arranged to receive the output of the inverter and the output of the NOR gate, and operable to deliver the said output signal (WD2).

3. A decoder circuit as claimed in claim 1 or 2 wherein said means comprise a clock signal generating circuit (CG) operable to generate a clock signal, which attains a predetermined level for the preselected time, in synchronisation with the transition of an address signal (Ao), for supply to the decoder circuit; the said other (Q21) of the pair of transistors of the load being connected for receiving said clock signal.

4. A decoder circuit as claimed in claim 3, wherein said one (Q22) of the pair of transistors of the load is connected for receiving the said output signal (WD2).

5. A decoder circuit as claimed in claim 2, 3 or 4, further comprising a third transistor (Q31) connected between the output of the NOR gate (QBo to QBn) and the output stage, a fourth transistor (Q32) connected between the common connection point of the third transistor and the output stage and a power supply line (Vcc) of the decoder circuit, and a capacitor (C) connected between the said common connection point and an output (WD2) of the output stage from which the said output signal is delivered.

6. A decoder circuit as claimed in claim 5, when read as appended to claim 3 or 4, wherein the fourth transistor (Q32) has a gate connected for receiving the said clock signal, and the third transistor (Q31) has a gate connected for receiving the output of the inverter (Q23, Q24).

7. A decoder circuit as claimed in 3 or 4, or claim 5 or 6 when read as appended to claim 3 or 4, wherein the clock signal generating circuit (CG) has an address buffer (ADo) operable in response to the transition of an address signal (Ao) to output the address signal (Ao) and a signal ($\overline{A}o$) inverted with respect to the address signal, delay inverter circuits connected respectively to receive the address signal and the inverted signal output from the address buffer, and first (Q63, Q64) and second (Q66, Q67) pairs of parallel-connected transistors, in one pair (Q66, Q67) the gate of one transistor (Q67) being connected to receive the address signal (Ao) output from the address buffer and the gate of the other transistor (Q66) being connected to receive the output of the delay inverter (Q62) connected to receive the inverted signal ($\overline{A}o$) from the address buffer, and in the other pair (Q63, Q64) the gate of one transistor (Q64) being connected to receive the inverted signal from the address buffer and the gate of the other transistor (Q63) being connected to receive the output of the delay inverter (Q61) connected to receive the address signal from the address buffer.

8. A decoder circuit as claimed in claim 7, the clock signal generating circuit further comprising means (Q69, Q70, Q71) operable to derive the NOR of the outputs of the first (Q63, Q64) and second (Q66, Q67) pairs of parallel-connected transistors, and an inverter (Q72, Q73) for inverting that NOR for supply as the said clock signal.

9. A semiconductor memory device including a decoder circuit as claimed in any preceding claim.

**Patentansprüche**

1. Dekoderschaltung, zum Beispiel für eine Halbleiterspeichervorrichtung, die betreibbar ist in Abhängigkeit von Adressensignalen (Ao bis An), die ihr zugeführt werden, um ein Ausgangssignal (WD2) bei entweder einem ersten, ausgewählten, oder einem zweiten, nicht ausgewählten Pegel zu liefern, in Abhängigkeit von den zugeführten Adressensignalen, mit einer Logikschaltungsstufe, die ein NOR-Glied (QBo bis QBn) hat, welches zum Empfang solcher Adressensignale angeordnet ist, wobei die Logikschaltungsstufe betreibbar ist, um einen logischen Ausgang mit einem Pegel in Abhängigkeit von den zugeführten Adressensignalen zu liefern und das NOR-Glied mit einer Last verbunden ist, die ein Paar von Transistoren (Q21, Q22) umfaßt, die parallel miteinander verbunden sind, von welchen Transistoren (Q22) einer angeordnet ist, um einzuschalten, wenn der logische Ausgang einen solchen Pegel hat, daß das Ausgangssignal den ausgewählten Pegel annimmt, und um auszuschalten, wenn der logische Ausgang einen solchen Pegel hat, daß das Ausgangssignal den nicht ausgewählten Pegel annimmt,

dadurch gekennzeichnet, daß Einrichtungen (CG) vorgesehen sind, die betreibbar sind, den anderen der Transistoren (Q21) der Last einzuschalten, eine vorbestimmte Zeit lang, in Synchronisation mit einem Übergang von einem Adressensignal (Ao).

2. Dekoderschaltung nach Anspruch 1, bei der die Logikschaltungsstufe ferner einen Inverter (Q23, Q24) umfaßt, der angeordnet ist, um den Ausgang des NOR-Gliedes (QBo bis QBn) zu empfangen, und bei der die Dekoderschaltung ferner eine Ausgangsstufe (Q25, Q26) umfaßt, die angeordnet sind, um den Ausgang des Inverters und den Ausgang des NOR-Gliedes zu empfangen, und betreibbar ist, um das genannte Ausgangssignal (WD2) zu liefern.

3. Dekoderschaltung nach Anspruch 1 oder 2, bei der die genannte Einrichtung eine Taktsignalgeneratorschaltung (CG) umfaßt, die betreibbar ist, um ein Taktsignal zu erzeugen, welches für eine vorbestimmte Zeitdauer einen vorbestimmten Pegel erreicht, in Synchronisation mit dem Übergang eines Adressensignals (Ao), für die Lieferung zu der Dekoderschaltung; und der genannte andere (Q21) des Paares von Transistoren der Last zum Empfang des genannten Taktsignals angeschlossen ist.

4. Dekoderschaltung nach Anspruch 3, bei der genannte eine (Q22) des Paares von Transistoren der Last zum Empfang des genannten Ausgangssignals (WD2) angeschlossen ist.

5. Dekoderschaltung nach Anspruch 2, 3 oder 4, ferner mit einem dritten Transistor (Q31), der zwischen dem Ausgang des NOR-Gliedes (QBo bis QBn) und der Ausgangsstufe verbunden ist, einem vierten Transistor (Q32), der zwischen dem gemeinsamen Verbindungspunkt des dritten Transistors und der Ausgangsstufe und einer Energieversorgungsleitung (Vcc) des Dekoderschaltung verbunden ist, und einem Kondensator (C), der zwischen dem genannten gemeinsamen Verbindungspunkt und einem Ausgangspunkt (WD2) der Ausgangsstufe, von der das genannte Ausgangssignal geliefert wird, verbunden ist.

6. Dekoderschaltung nach Anspruch 5, in Verbindung mit Anspruch 3 oder 4, bei der der vierte Transistor (Q32) ein Gate hat, das zum Empfang des genannten Taktsignals angeschlossen ist, und der dritte Transistor (Q31) ein Gate hat, das zum Empfang des Ausgangs des genannten Inverters (Q23, Q24) angeschlossen ist.

7. Dekoderschaltung nach Anspruch 3 oder 4, oder Anspruch 5 oder 6 in Verbindung mit Anspruch 3 oder 4, bei der die Taktsignalgeneratorschaltung (CG) umfaßt: eine Adressenpuffer (ADo), der in Abhängigkeit von dem Übergang eines Adressensignals (Ao) betreibbar ist, um das Adressensignals (Ao) und ein Signal ($\overline{A}o$), das in Bezug auf das Adressensignal invertiert ist, auszugeben,

Verzögerungsinverterschaltungen, die jeweils angeschlossen sind, um das Adressensignal und das invertierte Signal, die von dem Adressenpuffer ausgegeben werden, zu empfangen, und erste (Q63, Q64) und zweite (Q66, Q67) Paare von parallel angeschlossenen Transistoren, von denen in einem Paar (Q66, Q67) das Gate des einen Transistors (Q67) angeschlossen ist, um das Adressensignal (Ao) zu empfangen, das von dem Adressenpugger ausgegeben wird, und das Gate des anderen Transistors (Q66) angeschlossen ist, um den Ausgangs des Verzögerungsinverters (Q62) zu empfangen, der angeschlossen ist, um das invertierte Signal ($\overline{A}o$) von dem Adressenpuffer zu empfangen, und in dem anderen Paar (Q63, Q64) das Gate des einen Transistors (Q64) angeschlossen ist, um das invertierte Signal von dem Adressenpuffer zu empfangen, und das Gate des anderen Transistors (Q63) angeschlossen ist, um den Ausgangs des Verzögerungsinverters (Q61) zu empfangen, der angeschlossen ist, um das Adressensignal von dem Adressenpuffer zu empfangen.

8. Dekoderschaltung nach Anspruch 7, bei der die Taktsignalgeneratorschaltung ferner Einrichtungen (Q69, Q70, Q71) umfaßt, die betreibbar sind, um das NOR der Ausgänge des ersten (Q63, Q64) und zweiten (Q66, Q67) Paares von parallel verbundenen Transistoren abzuleiten, und einen Inverter (Q72, Q73) zum Invertieren dieses NOR, zur Zuführung als das genannte Taktsignal.

9. Halbleiterspeichervorrichtung mit einer Dekoderschaltung nach einem der vorhergehenden Ansprüche.

**Revendications**

1. Circuit décodeur, par exemple pour une mémoire à semi-conducteur, ayant pour fonction, en réponse à des signaux d'adresse (Ao à An) qui lui sont appliqués, de produire un signal de sortie (WD2) à un premier niveau sélectionné ou à un second niveau non sélectionné en fonction des signaux d'adresse appliqués, comportant une étage de circuit logique qui comprend une porte NON-OU (QBo à QBn) agencée pour recevoir les signaux d'adresse, l'étage de circuit logique ayant pour fonction de produire une sortie logique d'un niveau qui dépend des signaux d'adresse appliqués et la porte NON-OU étant connectée à une charge consistant en une paire de transistors (Q21, Q22) connectées en parallèle entre eux, l'un de ces transistors (Q22) étant agencé pour être débloqué quand la sortie logique est à un niveau tel que le signal de sortie adopte le niveau sélectionné et pour être bloqué quand la sortie logique est à un niveau tel que le signal sortie adopté le niveau non sélectionné, caractérisé en ce qu'un dispositif (CG) est prévu, ayant pour fonction de débloquer l'autre des transistors (Q21) de la charge pendant une durée prédéterminée en synchronisme avec une transition d'un signal d'adresse (Ao).

2. Circuit décodeur selon la revendication 1, dans lequel l'étage de circuit logique comporte en outre un inverseur (Q23, Q24) agencé pour recevoir la sortie de la porte NON-OU (QBo à ABn) et le circuit décodeur comportant en outre un étage de sortie (Q25, Q26) agencé pour recevoir la sortie de l'inverseur et la sortie de la porte NON-OU et ayant pour fonction de délivrer ledit signal de sortie (WD2).

3. Circuit décodeur selon la revendication 1 ou 2, dans lequel ledit dispositif comporte un circuit générateur de signal d'horloge (CG) ayant pour fonction de produire un signal d'horloge qui atteint un niveau prédéterminé pendant la durée prédéterminée, en synchronisme avec la transition d'un signal d'adresse (Ao) pour alimenter le circuit décodeur; l'autre (Q21) des deux transistors de la charge étant connecté pour recevoir ledit signal d'horloge.

4. Circuit décodeur selon la revendication 4, dans lequel ledit (Q22) parmi les deux transistors de la charge est connecté pour recevoir ledit signal de sortie (WD2).

5. Circuit décodeur selon la revendication 2, 3 ou 4, comportant en outre un troisième transistor (31) connecté entre la sortie de la porte NON-OU (QBo à QBn) et l'étage de sortie, un quatrième transistor (Q32) connecté entre le point de connexion commun du troisième transistor et de l'étage de sortie et une ligne d'alimentation (Vcc) du circuit décodeur et un condensateur (C) connecté entre ledit point de connexion commun et une sortie (WD2) de l'étage de sortie par lequel ledit signal de sortie est délivré.

6. Circuit décodeur selon la revendication 5, considérée comme annexée à la revendication 3 ou 4, dans lequel le quatrième transistor (Q32) comporte une grille connectée pour recevoir ledit signal d'horloge, le troisième transistor (Q31) comportant une grille connectée pour recevoir la sortie de l'inverseur (Q23, Q24).

7. Circuit décodeur selon la revendication 3 ou 4, ou la revendication 5 ou 6, considérée comme annexée à la revendication 3 ou 4, dans lequel le circuit générateur de signal d'horloge (CG) comporte un tampon d'adresse (ADo) ayant pour fonction, en réponse à la transition d'un signal d'adresse (Ao) d'émettre le signal d'adresse (Ao) et un signal (Āo) inversé par rapport au signal d'adresse, des circuits inverseurs retardés connectés respectivement pour recevoir le signal d'adresse et le signal inversé émis par le tampon d'adresse et une première (Q63, Q64) et une seconde (Q66, Q67) paires de transistors connectés en parallèle, dans une paire, (Q66, Q67) la grille d'un transistor (Q67) étant connectée pour recevoir le signal d'adresse (Ao) émis par le tampon d'adresse et la grille de l'autre transistor (Q66) étant connectée pour recevoir la sortie de l'inverseur retardé (Q62), connecté pour recevoir le signal inversé (Āo) provenant du tampon d'adresse et dans l'autre pair (Q63, Q64), la grille d'un transistor (Q64) étant connecté pour recevoir le signal inversé provenant du tampon d'adresse et la grille de l'autre transistor (Q63) étant connectée pour recevoir la sortie de l'inverseur retardé (Q61) connecté pour recevoir le signal d'adresse provenant du tampon d'adresse.

8. Circuit décodeur selon la revendication 7, dans lequel le circuit générateur de signal d'horloge comporte en outre un dispositif (Q69, Q70, Q71) ayant pour fonction de dériver la combinaison NON-OU des sorties de la première (Q63, Q4) et de la seconde (Q66 et Q67) paires de transistors connectés en parallèle et un inverseur (Q72, Q73) destiné à inverser cette combinaison NON-OU pour l'appliquer comme ledit signal d'horloge.

9. Mémoire à semi-conducteur comportant un circuit décodeur selon l'une quelconque des revendications précédentes.

Fig. 1

*Fig. 2*

*Fig. 3*

**Fig. 4**

**Fig. 5**

**Fig. 6**

Fig. 7

(a)

(b) $\overline{Ao}$

(c) $Ao$

(d) $Bo$

(e) $Co$

(f) $Do$

(g) $Eo$

(h) $F$

(i) $G$